# EUROPEAN PATENT APPLICATION

(11) **EP 2 450 958 A1**
(43) Date of publication of application: **09.05.2012**
(21) Application number: 10793918.3
(22) Date of filing: 14.05.2010
(51) Int. Cl.: H01L 31/04, C23C 16/24, C23C 16/509, H01L 21/205

(54) **PRODUCTION METHOD AND PRODUCTION DEVICE FOR SOLAR BATTERY**

(30) Priority: 30.06.2009 JP 2009155500
(71) Applicant: Sanyo Electric Co., Ltd., Osaka 570-8677 (JP)
(72) Inventor: MATSUMOTO, Mitsuhiro, Moriguchi-shi Osaka 570-8677 (JP); MURATA, Kazuya, Moriguchi-shi Osaka 570-8677 (JP)
(74) Representative: Cross, Rupert Edward Blount
(86) International application number: PCT/JP2010/058191
(87) International publication number: WO 2011/001747

(57) **Abstract**

When a solar battery configured by laminating a p-type layer, an i-type layer and an n-type layer in this order is produced, an n-type microcrystalline silicon thin film is formed as an n-type layer under film forming conditions wherein a ratio of the flow rate of an n-type dopant-containing gas to the flow rate of a silicon-containing gas is 0.03 or less, the ratio of the flow rate of a diluent gas to the flow rate of a silicon-containing gas is 70 or more, and the total pressure of a material gas is 200 Pa or more.

## Description

### BACKGROUND OF THE INVENTION

### Field of the Invention

The present invention relates to a production method and a production device for solar batteries.

### Description of the Related Art

A solar battery produced by employing polycrystalline, microcrystalline or amorphous silicon is well known. Particularly, from the perspectives of resource consumption, cost reduction and increased efficiency, the focus has been on the structure of a solar battery where microcrystalline or amorphous silicon thin films are laminated.

Generally, a thin-film solar battery is produced by laminating, on an insulating surface of a substrate, a first electrode, one or more semiconductor thin-film photoelectric conversion cells and a second electrode, in the stated order. The individual solar battery units have a laminated structure consisting of a p-type layer, an i-type layer and an n-type layer, beginning at the side through which light enters.

Further, a method for laminating two or more photoelectric conversion cells, aligned in the direction in which light enters the battery, is a known method used for increasing the conversion efficiency of a thin-film solar battery. A first solar battery unit, which includes a photoelectric conversion layer having a broad band gap, is arranged on the side of a thin-film solar battery where light enters, while a second solar battery unit, which includes a photoelectric conversion layer having a narrower band gap than that provided by the first solar battery unit, is arranged following the first solar battery unit. With this arrangement, photoelectric conversion can be performed across a wide range of wavelengths of incident light, and the overall conversion efficiency of the device can be increased.

There is, as an example, a well known structure wherein an amorphous silicon (a-Si) solar battery unit is employed as a top cell, and a microcrystalline (µc-Si) solar battery unit is employed as a bottom cell. Furthermore, the intervals at which plasma electrodes are arranged have been disclosed for production methods and production devices for amorphous solar battery units (see Patent Literature 1 to 3 below). For example, a production method for an amorphous silicon thin-film photoelectric conversion device is disclosed in Patent Literature 1. According to this conventional example, a microcrystalline silicon layer is employed as the n-type layer of an amorphous solar battery unit, and as the conditions for forming this n-type layer, a material gas mixture of a silane gas and a diluent gas containing hydrogen is employed, the flow rate of the diluent gas is four times or less than that of the silane gas, the partial pressure of the silane gas is 1.2 Torr or higher to 5.0 Torr or lower, and the distance from plasma electrodes to a substrate is 8 mm or greater to 15 mm or smaller.
Patent Literature 1: JP No. 3046965B
Patent Literature 2: JP No. 08-306944A
Patent Literature 3: JP No. 09-27628A

When a microcrystalline silicon layer is employed as the n-type layer of an amorphous solar battery unit, generally, the activation rate of a dopant is increased, compared with when an amorphous silicon layer is employed, and accordingly, the open circuit voltage Voc is raised and a short circuit current Jsc is also increased because a loss due to light absorption is reduced.

Therefore, for an amorphous solar battery unit wherein a microcrystalline layer is employed as an n-type layer, it is demanded that the deposition conditions for the n-type layer should be optimized in order to obtain higher conversion efficiency for a thin-film solar battery.

### SUMMARY OF THE INVENTION

One objective of the present invention is to provide a solar battery production method and a production device that can resolve the above described problem.

According to one aspect of the present invention, a solar battery production method for forming a solar battery includes a step of:
laminating on a substrate, in the stated order, a p-type thin film that has a p-type dopant added, an i-type amorphous silicon thin-film and an n-type microcrystalline silicon thin film that has an n-type dopant added,
wherein a ratio of a flow rate of an n-type dopant-containing gas to a flow rate of a silicon-containing gas is 0.03 or smaller, a ratio of a flow rate of a diluent gas to a flow rate of a silicon-containing gas is 70 or greater, and the total pressure of a material gas is 200 Pa or higher.

For forming the n-type microcrystalline silicon thin film, it is appropriate that electric power to be supplied for generation of plasma of a material gas be 80 mW/cm² or more to 600 mW/cm² or less per unit area of a plasma electrode.

Further, it is appropriate that the flow rate of the silicon-containing gas be 0.01 sccm/cm² or less per unit area of the substrate.

Furthermore, for forming the n-type microcrystalline silicon thin film, it is appropriate that a gap between a surface of the substrate and an opposed plasma electrode be 20 mm or smaller. This arrangement is effective especially for a case where the substrate is transferred while mounted on a substrate carrier, and is heated by a substrate heater separated from the substrate carrier by a gap in order to form the n-type microcrystalline silicon thin film. Further, this arrangement is especially effective, for example, for a vertical in-line production device that transfers a substrate upright.

Moreover, it is appropriate that the i-type amorphous silicon thin film and the n-type microcrystalline silicon thin film be formed in a single deposition chamber.

According to the present invention, the conversion efficiency of the thin-film solar battery can be further increased.

### BRIEF DESCRIPTION OF THE DRAWINGS

Fig. 1 is a cross-sectional view of the structure of a tandem solar battery according to one embodiment of the present invention;
Fig. 2 is an enlarged cross-sectional view of the structure of the a-Si unit of the tandem solar battery according to the embodiment of the present invention;
Fig. 3 is a diagram illustrating the arrangement of an example production device for the tandem solar battery for the embodiment of the present invention;
Fig. 4 is a diagram illustrating the internal structure of the deposition chamber of the tandem solar battery according to the embodiment of the present invention; and
Fig. 5 is a diagram illustrating another example production device for the tandem solar battery of the embodiment of the present invention.

### DETAILED DESCRIPTION OF THE PREFERRED EMBODIMENT

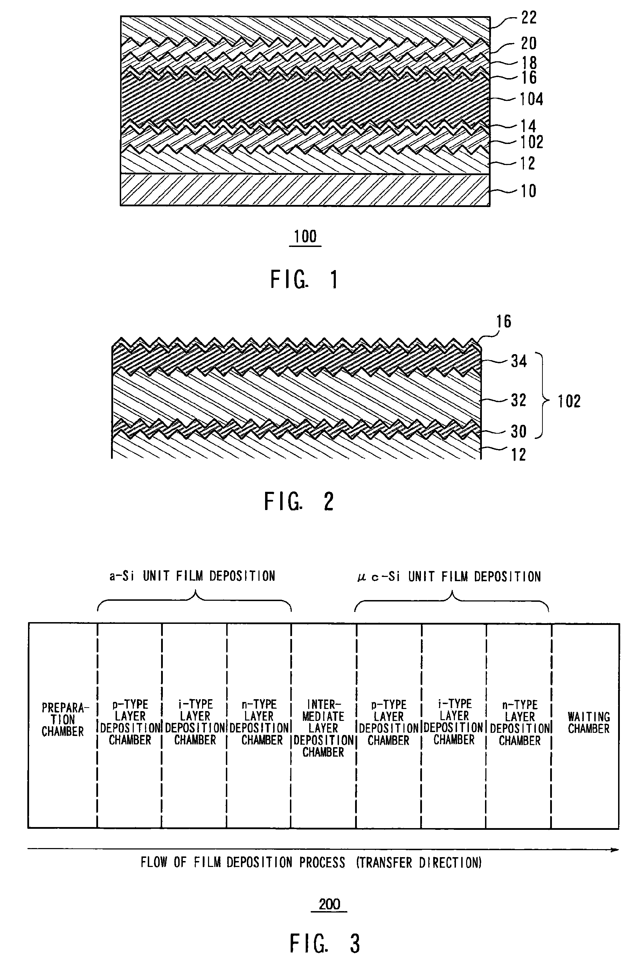

Fig. 1 is a cross-sectional view of the structure of a tandem solar battery 100 according to one embodiment of the present invention. The tandem solar battery 100 of this embodiment is provided by laminating, on a transparent insulating substrate 10 that is located on the side through which light enters, a transparent conducting film 12, an amorphous silicon (a-Si) (photoelectric conversion) unit 102 that has a wide band gap and that serves as a top cell, an intermediate layer 14, a microcrystalline silicon (µc-Si) (photoelectric conversion) unit 104 that has a narrower band gap than the a-Si unit 102 and that serves as a bottom cell, a first back-side electrode layer 16, a second back-side electrode layer 18, a filler 20 and a protective film 22, beginning at the side through which light enters.

The structure of the tandem solar battery 100 for the embodiment of the present invention and a production method for the tandem solar battery 100 will now be described. The tandem solar battery 100 of this embodiment is characterized by a production method for an n-type layer included in the a-Si unit 102.

The transparent insulating substrate 10 can be a substrate, such as a glass substrate or a plastic substrate, made of a material that exhibits transparency, at least within the wavelength range of visible light. The transparent conducting film 12 is deposited on the transparent insulating substrate 10, and to form the transparent conducting film 12, it is appropriate that either a single type or a plurality of types of transparent conductive oxides (TCOs) be selected from among a group including tin(IV) oxide (SnO₂), zinc oxide (ZnO) and indium tin oxide (ITO), for which doping with tin (Sn), antimony (Sb), fluorine (F) and aluminum (Al) has been performed. Above all, zinc oxide (ZnO) is especially preferable because of high translucency, low resistivity and superior plasma resistance. The transparent conducting film 12 can be formed by using sputtering, and an appropriate thickness for the transparent conducting film 12 is one within a range of from 0.5 µm to 5 µm. Furthermore, it is appropriate that the surface of the transparent conducting film 12 have surface irregularities in order to provide a light trapping effect.

A p-type layer 30, an i-type layer 32 and an n-type layer 34, all of which are silicon thin films, are laminated, in the stated order, on the transparent conducting film 12 to form the a-Si unit 102. Fig. 2 is an enlarged cross-sectional view of a portion of the a-Si unit 102.

The a-Si unit 102 can be formed using plasma-enhanced CVD, which is a film deposition method by which to perform plasma activation of a material gas that is a mixture of a silicon-containing gas, such as silane (SiH₄), disilane (Si₂H₆) or dichlorosilane (SiH₂Cl₂), a carbon-containing gas such as methane (CH₄), a p-type dopant-containing gas such as diborane (B₂H₆), an n-type dopant-containing gas such as phosphine (PH₃), and a diluent gas of hydrogen (H₂), for example.

Plasma CVD can be performed, for example, by an in-line type production device 200 shown in Fig. 3. The in-line type production device 200 in Fig. 3 sequentially produces both the a-Si unit 102 and the µc-Si unit 103. The in-line production device 200 includes: a preparation chamber; film deposition chambers for the p-type layer 30, the i-type layer 32 and the n-type layer 34 of the a-Si unit 102; a film deposition chamber for an intermediate layer; film deposition chambers for the p-type layer, the i-type layer and the n-type layer of the µc-Si unit 104; and a waiting chamber, all of which are arranged one after another. The individual chambers are connected by gate valves, so that the transparent insulating substrate 10 can be transferred in order, in the transfer direction, to the individual film deposition chambers. With this arrangement, during the film deposition processing a plurality of thin films can be sequentially formed, without any individual film deposition chamber affecting the others. Furthermore, during the deposition of each thin film, the transparent insulating substrate 10 is protected from exposure to the atmosphere, and the entry of impurities is prevented, so that high quality thin films can be formed and efficient production of solar batteries is ensured.

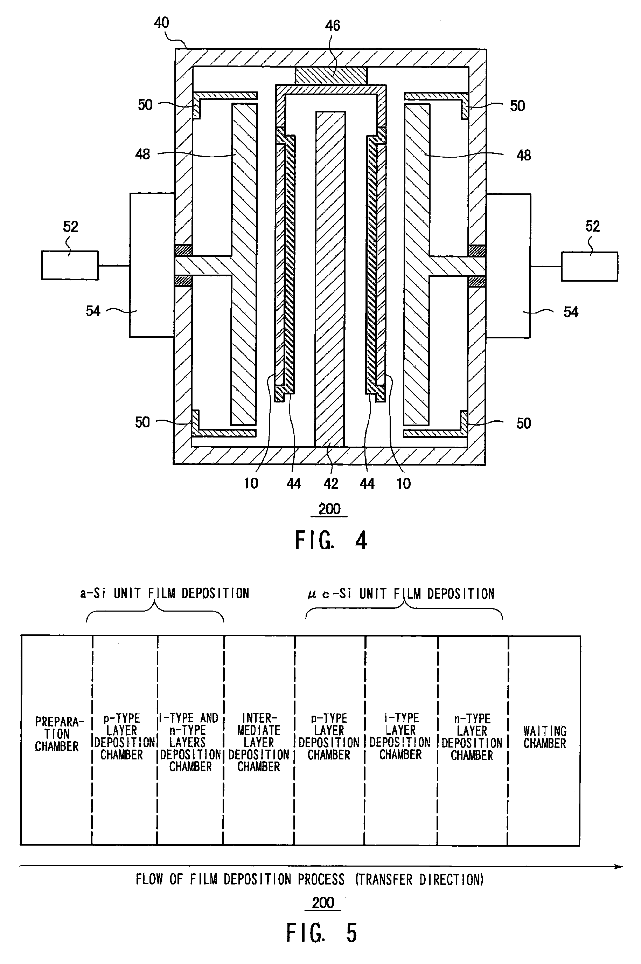

The internal structure of the in-line type production device 200 is shown in Fig. 4. Fig. 4 is a cross-sectional view of the in-line type production device 200, taken perpendicular to the direction in which the transparent insulating substrate 10 is transferred (direction perpendicular to the face of a paper sheet). The in-line type production device 200 in Fig. 4 is a vertical type device in which the transparent insulating substrate 10 is transferred upright.

Generally, the individual film deposition chambers are employed to form the p-type layer 30, the i-type layer 32 and the n-type layer 34, respectively, but since the internal structures of all these chambers are the same, only the deposition chamber for the n-type layer 34 is employed for the description.

For the production device 200, a substrate heater 42, substrate carriers 44, a transfer device 46, plasma electrodes 48 and shields 50 are arranged in the film deposition chamber enclosed by chamber walls 40. The plasma electrodes 48 are electrically connected to plasma power supplies 52 by matching boxes 54, located outside the film deposition chamber. Air in the film deposition chamber can be exhausted by a vacuum pump (not shown) to produce a vacuum. The production device 200 of this embodiment can transfer two of the transparent insulating substrates 10 at the same time, and can also simultaneously perform film deposition for the two.

The substrate heater 42 is located in the center of the transfer path in the film deposition chamber, and the heating face is opposite the plasma electrodes 48 that are arranged along both side walls of the film deposition chamber. The substrate carriers 44 are to be moved by the transfer device 46 in the transfer direction. When the transparent insulating substrates 10 are to be transferred with the substrate carriers 44, the substrates 10 are held upright, between the plasma electrodes 48 and the substrate heater 42, so that they face the plasma electrodes 48. When the substrate carriers 44 are moved by the transfer device 46, the transparent insulating substrates 10 are transferred from one deposition chamber of the production device 200 to another. The substrate carriers 44 serve not only as ground electrodes for the generation of plasma, but also as susceptors that transmit heat received from the substrate heater 42 to the transparent insulating substrates 10.

RF power is supplied by the plasma power supplies 52 to the plasma electrodes 48 via the matching boxes 54. The matching boxes 54 are employed for impedance adjustment, so that plasma will be generated between the transparent insulating substrates 10 and the plasma electrodes 48 of the production device 200. Spray holes for supplying a material gas from a gas supply line (not shown) may be formed for the plasma electrodes 48.

Further, the shields 50 may be provided for the production device 200. The shields 50 are employed to prevent plasma deposition of films on unwanted areas in the film deposition chamber.

With this arrangement, when the material gas is supplied at a flow rate and a pressure that conform to the film deposition conditions, and the electric power is supplied to the plasma electrodes 48 by the plasma power supplies 52, plasma of the material gas is generated at the gap between the plasma electrodes 48 and the transparent insulating substrates 10, and films are formed on the surfaces of the transparent insulating substrates 10. A method for forming the tandem solar battery 100 will now be described in detail.

The transparent conducting film 12 of several 100 nm thick is deposited on the transparent insulating substrate 10, and has surface irregularities. Also, when a solar battery cell is to be integrated, using a combination of series and parallel connections, a YAG laser may be employed to form a strip-shaped pattern for the transparent conducting film 12.

The p-type layer 30 is deposited on the transparent conducting film 12. The p-type layer 30 is either a single layer made of amorphous silicon, microcrystalline silicon or microcrystalline silicon carbide, or a composite layer consisting of some of these layers.

For example, the p-type layer 30 may be a composite layer such that the film thicknesses of the component layers are increased in the direction leading from the transparent conducting film 12 to the i-type layer 32, and that an amorphous silicon carbide layer, for which the light absorption coefficient changes relative to light of a specific wavelength, is included in these layers. Further, in order to avoid an effect produced by plasma during the adjustment of the band gap and the formation of the i-type layer 32, a buffer layer made of amorphous silicon carbide or microcrystalline silicon carbide may be deposited on the amorphous silicon carbide layer, having low light absorption. More specifically, for example, an amorphous silicon carbide layer having high light absorption, which has been doped by adding a p-type dopant (e.g., boron) at a first doping density, is deposited on the transparent conducting film 12, and an amorphous silicon carbide layer, having low light absorption, that has been doped by adding a p-type dopant (e.g., boron) at a second doping density, lower than the first doping density, is deposited on the amorphous silicon carbide layer having high light absorption. In this case, it is appropriate for the second doping density to be from 1/5th to 1/10th of the first doping density.

Furthermore, the structure of the p-type layer 30 may be, for example, a lamination of an amorphous silicon carbide layer doped by adding a p-type dopant (e.g., boron), a silicon layer formed by not adding a p-type dopant and a buffer layer formed by not adding a p-type dopant.

When plasma CVD is performed to form the p-type layer 30, a mixture ratio of a silicon-containing gas, a carbon-containing gas, a p-type dopant-containing gas and a diluent gas, the pressure and RF power for plasma generation can be adjusted. It is preferable that the electric power supplied be RF power of 13.56 MHz, and that the power density per unit area of the plasma electrode be 5 mW/cm² or greater to 100 mW/cm² or smaller.

The i-type layer 32, deposited on the p-type layer 30, is an undoped amorphous silicon layer having a thickness of 50 nm or greater to 500 nm or smaller. The film property of the i-type layer 32 can be changed by adjusting the mixture ratio of a silicon-containing gas and a diluent gas, and the pressure and the RF power for plasma generation. It is preferable that the electric power to be supplied be RF power of 13.56 MHz, and that the power density per unit area of the plasma electrode be 5 mW/cm² or greater to 100 mW/cm² or smaller. The i-type layer 32 is employed as a power generation layer for the a-Si unit 102.

The n-type layer 34, deposited on the i-type layer 32, is an n-type microcrystalline silicon layer (n-type µc-Si:H), with a thickness of 10 nm or greater to 100 nm or smaller, that has been doped by adding an n-type dopant (e.g., phosphorus). The film property of the n-type layer 34 can be changed by adjusting the mixture ratio for a silicon-containing gas, a carbon-containing gas, an n-type dopant-containing gas and a diluent gas, and the pressure and the RF power for plasma generation. It is preferable that the electric power that is supplied be RF power of 13.56 MHz, and that the power density per unit area of the plasma electrode be 80 mW/cm² or greater to 600 mW/cm² or smaller.

It is preferable that the pressure of a material gas employed for the deposition of the n-type layer 34 be higher than that for the deposition of the i-type layer 32. Specifically, it is appropriate, for the formation of the n-type layer 34, that the pressure of the material gas, which is a mixture of a silicon-containing gas, a carbon-containing gas, an n-type dopant-containing gas and a diluent gas, be higher than 200 Pa, preferably, 250 Pa or higher. When the power density is in the range employed for the formation of the n-type layer 34, plasma might be generated unevenly under a pressure exceeding 650 Pa. Because of uneven generation of plasma, an amorphous area tends to be formed at the four corners of the substrate, and it is difficult for the n-type microcrystalline silicon to be formed across the entire surface of the transparent insulating substrate 10. This is why it is appropriate for the pressure employed for deposition to be 650 Pa or lower. Further, when the substrate heater 42 and the substrate carriers 44 are located at a distance from each other, there is a case where, under a deposition pressure exceeding 400 Pa, abnormal plasma discharge occurs between the substrate header 42 and the substrate carriers 44. This is why it is appropriate for the pressure employed for deposition be 400 Pa or lower.

Furthermore, when silane (SiH₄) is employed as a silicon-containing gas, hydrogen (H₂) is employed as a diluent gas and phosphine (PH₃) is employed as an n-type dopant-containing gas, a material gas can be appropriately employed that is a mixture of silane (SiH₄), hydrogen (H₂) and phosphine (PH₃) at a ratio of the flow rates of 1: 7.0 or higher : 0.03 or lower, respectively. At this time, it is appropriate for silane (SiH₄) to be supplied at a flow rate of 0.01 sccm/cm² per unit area of the transparent insulating substrate 10 for which the deposition is to be performed.

Thereafter, the intermediate layer 14 is deposited on the a-Si unit 102. It is appropriate for a transparent conducting oxide (TCO), such as zinc oxide (ZnO) or silicon oxide (SiOx) , to be employed for the intermediate layer 14. It is especially appropriate for zinc oxide (ZnO) or silicon oxide (SiOx), doped by adding magnesium (Mg), to be employed. The sputtering process, for example, can be employed for deposition of the intermediate layer 14. The appropriate thickness for the intermediate layer 14 is within the range 10 nm or greater to 200 nm or smaller. It should be noted that it is not always necessary for the intermediate layer 14 to be formed.

The p-type layer, the i-type layer and the n-type layer are laminated, in order, on the intermediate layer 14, to provide the µc-Si unit 104.

The µc-Si unit 104 can be formed by plasma CVD, whereby film deposition is performed by plasma activation using a material gas that is a mixture of a silicon-containing gas, such as silane (SiH₄), disilane (Si₂H₆) or dichlorosilane (SiH₂Cl₂), a carbon-containing gas such as methane (CH₄), a p-type dopant-containing gas such as diborane (B₂H₆), an n-type dopant-containing gas such as phosphine (PH₃), and a diluent gas such as hydrogen (H₂).

As the plasma CVD method, RF plasma enhanced CVD at 13.56 MHz can be appropriately employed for the formation of the µc-Si unit 104 as well as the a-Si unit 102, and parallel-plate electrodes can be employed for the RF plasma enhanced CVD. Further, spray holes for supplying a material gas may be formed in the parallel-plate electrodes on the side where the transparent insulating substrate 10 is not arranged. It is preferable that the power density for supplying plasma be 5 mW/cm² or greater to 100 mW/cm² or smaller.

The µc-Si unit 104 is formed by laminating, for example, a p-type microcrystalline silicon layer (p-type µc-Si:H) having a thickness of 5 nm or greater to 50 nm or smaller, which has been doped by adding boron, an undoped i-type microcrystalline silicon layer (i-type µc-Si : H) having a thickness of 0.5 µm or greater to 5 µm or smaller, and an n-type microcrystalline silicon layer (n-type µc-Si:H) having a thickness of 5 nm or greater to 50 nm or smaller, which has been doped by adding phosphorus.

A unit formed in this case is not limited to the µc-Si unit 104, and any other unit can be employed that includes an i-type microcrystalline silicon layer (i-type µc-Si:H) as a power generation layer.

When a solar battery cell is to be integrated using a combination of series and parallel connections, patterning of the a-Si unit 102 and the µc-Si unit 104 is performed by emitting a YAG laser beam to a side location 50 µm from the position at which the patterning of the transparent conducting film 12 was performed.

Then, the first back-side electrode layer 16 and the second back-side electrode layer 18, formed of a reflective metal and a transparent conducting oxide (TCO), respectively, are laminated on the µc-Si unit 104. A metal, such as silver (Ag) or aluminum (Al), can be employed for the first back-side electrode layer 16, and a transparent conducting oxide (TCO), such as tin(IV) oxide (SnO₂), zinc oxide (ZnO) or indium tin oxide (ITO), can be employed for the second back-side electrode layer 18. The TCO layer can be formed, for example, by sputtering. Further, it is appropriate that the total of the thicknesses for the first back-side electrode layer 16 and the second back-side electrode layer 18 be about 1 µm. Furthermore, at least either the first back-side electrode layer 16 or the second back-side electrode layer 18 has surface irregularities in order to provide a light confinement effect.

Furthermore, the surface of the second back-side electrode layer 18 is covered with the protective film 22, using the filler 20. The filler 20 and the protective film 22 are made of a resin material, such as EVA or polyimide. With this structure, the entry of water into the power generation layer of the tandem solar battery 100 can be prevented.

The production method for the tandem solar battery 100 of this embodiment has been described. In this embodiment, the in-line type production device 200 has been employed, wherein separate deposition chambers are provided for the i-type layer 32 and the n-type layer 34 of the a-Si unit 102. However, as shown in Fig. 5, a single-water type production device 200 may be employed, wherein the same film deposition chamber is used for the i-type layer 32 and the n-type layer 34 of the a-Si unit 102. With this structural form, the production speed of the a-Si unit 102 can be increased.

### <Examples>

Examples for the present invention and comparison examples will now be described. For the following examples, the transparent insulating substrate 10 was a glass substrate, having the rectangular dimensions of 33 cm x 43 cm and a thickness of 40 mm, on which an SnO₂ film of 600 nm thickness, having surface irregularities, was deposited as the transparent conducting film 12 by thermal CVD. For the deposition of the transparent conducting film 12, a YAG laser having a wavelength of 1064 nm was employed at an energy density of 13 J/cm³ and a pulse frequency of 3 kHz, and formed a strip-shaped pattern.

Furthermore, for the production device 200, the plasma electrodes 48 were of a shower plate type, from the surfaces of which a material gas can be sprayed like a shower, and the dimensions of the electrodes 48 were 2675 cm².

The p-type layer 30, the i-type layer 32 and the n-type layer 34 were deposited, in order, on the transparent insulating substrate 10. The deposition conditions for the p-type layer 30 and the i-type layer 32 are shown in Table 1, and the deposition conditions for the n-type layer 34 are shown in Table 2. As examples 1 to 3, the n-type layer 34 was formed under conditions where the ratio of the flow rates for silane (SiH₄), hydrogen (H₂) and phosphine (PH₃) was 1:100:0.01, the total pressure for a material gas ranged from 200 Pa to 280 Pa, and the power density supplied to the plasma electrodes 48 was 112 mW/cm². As comparison example 1, the n-type layer 34 was formed under the condition where the total pressure for the material gas was 160 Pa. As comparison example 2, the n-type layer 34 was formed under deposition conditions where the ratio of the flow rates for silane (SiH₄), hydrogen (H₂) and phosphine (PH₃) was 1:3:0.01, the total pressure for the material gas was 160 Pa, and the power density supplied to the plasma electrodes 48 was 15 mW/cm². It should be noted that when the ratio of the flow rate of silane (SiH₄) to that of hydrogen (H₂) was smaller than 1:70, an n-type microcrystalline silicon layer was not formed, and instead, an n-type amorphous silicon layer was deposited.

**[Table 1]**

| Layer | Substrate Temp. (°C) | Gas Flow Rate (sccm) | Reaction Pressure (Pa) | RF Power (W) | Film Thickness (nm) |
|---|---|---|---|---|---|
| p-type Layer | 180 | SiH₄:20-40 | 80 | 30 | 25-50 |
| | | CH₄: 0-80 | | | |
| | | B₂H₆:0-0.12 | | | |
| | | H₂:400-2000 | | | |
| i-type Layer | 200 | SiH₄:300 | 80 | 30 | 250 |
| | | H₂:2000 | | | |

**[Table 2]**

| | Substrate Temp.(°C) | Gas Flow Rate (sccm) | Reaction Pressure (Pa) | RF Power (mW/cm²) | Distance, Electrode To Substrate (mm) |
|---|---|---|---|---|---|
| Example 1 | 180 | SiH₄:20 | 200 | 112 | 18 |
| | | H₂:2000 | | | |
| | | PH₃:0.2 | | | |
| Example 2 | 180 | SiH₄:20 | 250 | 112 | 18 |
| | | H₂:2000 | | | |
| | | PH₃:0.2 | | | |
| Example 3 | 180 | SiH₄:20 | 280 | 112 | 18 |
| | | H₂:2000 | | | |
| | | PH₃:0.2 | | | |
| Comparison Example 1 | 180 | SiH₄:20 | 160 | 112 | 18 |
| | | H₂:2000 | | | |
| | | PH₃:0.2 | | | |
| Comparison Example 2 | 180 | SiH₄:80 | 160 | 15 | 18 |
| | | H₂:240 | | | |
| | | PH₃:0.8 | | | |

Table 3 shows the deposition conditions for the µc-Si unit 104. The deposition conditions for the µc-Si unit 104, however, are not limited to those shown.

**[Table 3]**

| Layer | Substrate Temp.(°C) | Gas Flow Rate (sccm) | Reaction Pressure (Pa) | RF Power (W) | Film Thickness (nm) |
|---|---|---|---|---|---|
| p-type Layer | 180 | SiH₄:10 | 106 | 10 | 10 |
| | | H₂:2000 | | | |
| | | B₂H₆:3 | | | |
| i-type Layer | 200 | SiH₄:100 | 133 | 20 | 2000 |
| | | H₂:2000 | | | |
| n-type Layer | 200 | SiH₄:10 | 133 | 20 | 20 |
| | | H₂:2000 | | | |
| | | PH₃:5 | | | |

Thereafter, a YAG laser beam was emitted to a side location 50 µm from the position where patterning was performed for the transparent conducting film 12, and strip-shaped patterns were formed for the a-Si unit 102 and the µc-Si unit 104. For this procedure, a YAG laser was employed that had an energy density of 0.7 J/cm³ and a pulse frequency of 3 kHz.

Following this, an Ag electrode was deposited, by sputtering, as the first back-side electrode layer 16, and a ZnO film was deposited, also by sputtering, as the second back-side electrode film. Then, the YAG laser was emitted to a side location 50 µm from the patterning position for the a-Si unit 102 and the µc-Si unit 104 in order to form strip-shaped patterns for the first back-side electrode layer 16 and the second back-side electrode layer 18. A YAG laser having an energy density of 0.7 J/cm³ and a pulse frequency of 4 kHz was employed.

When formation of a tandem solar battery was completed, an annealing process for the solar battery was performed for two hours, in the atmosphere, at 150°C. Table 4-1 and 4-2 show open circuit voltages Voc, short circuit currents Jsc, fill factors FF and efficiencies η for the tandem solar batteries for examples 1 to 3 and for comparison examples 1 and 2, before and after the annealing process was performed. In Table 4-1 and 4-2, the open circuit voltage Voc, the short circuit current Jsc, the fill factor FF and the efficiency η for comparison example 2 are designated as 1, and the ratios of these categories in examples 1 to 3 and comparison example 1 are shown relative to those in comparison example 2.

**[Table 4-1]**

| | Before Annealing | | | |
|---|---|---|---|---|
| | Open Circuit Voltage (Voc) | Short Circuit Current (Jsc) | F.F. | Efficiency (η) |
| Example 1 | 1.01 | 1.01 | 0.98 | 0.99 |
| Example 2 | 1.01 | 1.01 | 0.99 | 1.01 |
| Example 3 | 1.01 | 1.01 | 1.00 | 1.03 |
| Comparison Example 1 | 1.01 | 1.01 | 0.94 | 0.96 |
| Comparison Example 2 | 1 | 1 | 1 | 1 |

**[Table 4-2]**

| | After Annealing | | | |
|---|---|---|---|---|
| | Open Circuit Voltage (Voc) | Short Circuit Current (Jsc) | F.F. | Efficiency (η) |
| Example 1 | 1.01 | 1.01 | 1.02 | 1.04 |
| Example 2 | 1.01 | 1.02 | 1.02 | 1.05 |
| Example 3 | 1.01 | 1.02 | 1.02 | 1.04 |
| Comparison Example 1 | 1.01 | 1.00 | 0.97 | 0.98 |
| Comparison Example 2 | 1 | 1 | 1 | 1 |

When a microcrystalline silicon layer was employed as the n-type layer 34, as in examples 1 to 3, the open circuit voltage Voc and the short circuit current Jsc were increased, and accordingly, the fill factor FF was increased, compared with when an amorphous silicon layer was employed as the n-type layer 34 in comparison example 2. This indicates that since a microcrystalline silicon layer was employed as the n-type layer, the activation rate of a dopant in the layer was increased to raise the open circuit voltage Voc, and loss due to light absorption was reduced to thereby increase the short circuit current Jsc.

Further, when, as in examples 1 to 3, the pressure of the material gas was 200 Pa or higher during film deposition for the n-type layer 34, the short circuit current Jsc and the fill factor FF obtained after the annealing process were increased, compared with when the pressure was lower than 160 Pa, as in comparison example 2. This is probably because when the n-type layer 34 was deposited under low pressure, the structure of the microcrystalline silicon layer was altered by ion bombardment during film deposition, and the film property was degraded. In a case where another layer is laminated on such an n-type layer 34, it is assumed that electric contacts between the layers will be deteriorated, while the series resistance will be increased, so that the short circuit current Jsc and the fill factor FF will be lowered. When the pressure of the material gas for film deposition of the n-type layer 34 is 200 Pa, the property is improved by the annealing process, but in a case where the pressure is only 160 Pa, damage to the n-type layer 34 will be too great, and adequate recovery of the property will not occur. Furthermore, when the pressure of the material gas is below 200 Pa, the efficiency η obtained before the annealing process is lower than that in comparison example 2.

When the flow rate of silane (SiH₄) exceeded 0.01 sccm/cm² per unit area of the transparent insulating substrate 10 for which film deposition was being performed, silicon flakes (tiny pieces formed of silicon powder) were generated during film deposition, and were attached to the inner walls of the deposition chambers. It is therefore assumed that this deposition condition is not suitable, based on the industrial aspect.

When the pressure of the material gas was increased for deposition of the n-type layer 34, and when the power density to be supplied to the plasma electrodes 48 was less than 80 mW/cm², the spatial uniformity for plasma generation was degraded and the plasma density on the periphery of the plasma electrodes 48 was lowered, so that a microcrystalline silicon layer could not be deposited, as the n-type layer 34, across the entire surface. Particularly, when the dimensions of the plasma electrodes 48 were increased, the spatial non-uniformity of plasma was increased. Furthermore, when the power density to be supplied to the plasma electrodes 48 exceeded 600 mW/cm², it was noticeable that silicon flakes (tiny pieces formed of silicon powder) were generated during film deposition, and were attached not only to the inner walls of the film deposition chambers, but were also attached to the substrate holders. It is therefore assumed that such a film deposition condition is not suitable for the industrial aspect.

Moreover, for film deposition of the n-type layer 34, when there was a distance exceeding 20 mm between the surface of the transparent insulating substrate 10 and each plasma electrode 48 facing the transparent insulating substrate 10, the plasma density on the periphery of the plasma electrodes 48 was reduced, and a microcrystalline silicon layer could not, as the n-type layer 34, be deposited across the entire surface. Especially, for the vertical in-line type production device 200 where there are gaps between the substrate heater 42 and the substrate carriers 44, and between the shields 50 and the plasma electrodes 48, when the distance between the transparent insulating substrate 10 and the plasma electrodes 48 is greater than 20 mm, an abnormal plasma discharge may occur in these gaps. Therefore, it is appropriate for the distance between the surface of the transparent insulating substrate 10 and each opposite plasma electrode 48 to be equal to or smaller than 20 mm.

## Claims

1. A solar battery production method for forming a solar battery comprising a step of:
laminating, on a substrate, a p-type thin film that has a p-type dopant added, an i-type amorphous silicon thin-film and an n-type microcrystalline silicon thin film that has an n-type dopant added,
wherein, in the step of forming the n-type microcrystalline silicon thin film, a ratio of a flow rate of an n-type dopant-containing gas to a flow rate of a silicon-containing gas is 0.03 or smaller, a ratio of a flow rate of a diluent gas to a flow rate of a silicon-containing gas is 70 or greater, and the total pressure of a material gas is 200 Pa or higher.

2. The solar battery production method according to claim 1, wherein for forming the n-type microcrystalline silicon thin film, electrical power to be supplied for generation of plasma of a material gas is 80 mW/cm² or more to 600 mW/cm² or less per unit area of a plasma electrode.

3. The solar battery production method according to claim 1, wherein the flow rate of the silicon-containing gas is 0.01 sccm/cm² or less per unit area of the substrate.

4. The solar battery production method according to claim 1, wherein for forming the n-type microcrystalline silicon thin film, a gap between a surface of the substrate and an opposed plasma electrode is 20 mm or smaller.

5. The solar battery production method according to claim 1, wherein the i-type amorphous silicon thin film and the n-type microcrystalline silicon thin film are formed in a single deposition chamber.

6. The solar battery production method according to claim 4, wherein the substrate is transferred while mounted on a substrate carrier; and wherein the substrate is heated by a substrate heater separated from the substrate carrier by a gap in order to form the n-type microcrystalline silicon thin film.

7. The solar battery production method according to claim 4, wherein the substrate is transferred upright.
